# EUROPEAN PATENT SPECIFICATION

(11) **EP 0 323 123 B1**
(45) Date of publication and mention of the grant of the patent: **24.04.1996**
(21) Application number: 88312140.2
(22) Date of filing: 21.12.1988
(51) Int. Cl.: G06F 11/20, G06F 11/00, G06F 12/16

(54) **A storage control system in a computer system**
Speichersteuersystem in einem Rechnersystem
Système de commande de mémoire dans un système de calcul

(30) Priority: 24.12.1987 JP 325437/87
(43) Date of publication of application: 05.07.1989
(73) Proprietor: FUJITSU LIMITED, Kawasaki-shi, Kanagawa 211 (JP)
(72) Inventor: Ikeda, Masayuki Eshiiru Nakahara 404, 629-12, Kawasaki-shi Kanagawa 211 (JP); Ueda, Koichi Mizonokuchi Hausu 106, 618-1, Kawasaki-shi Kanagawa 213 (JP)
(74) Representative: Billington, Lawrence Emlyn

(56) References cited:
- 1986 PROCEEDINGS FALL JOINT COMPUTER CONFERENCE, Dallas texas, 2nd - 6th November 1986, pages 1128-1137; R.F. RASHID: "From RIG to accent to mach: The evolution of a network operating system"
- PATENT ABSTRACTS OF JAPAN, vol. 6, no. 159 (P-136), 20th August 1982; & JP-A-57 074 898 (NEC CORP.) 11-05-1982
- IBM TECHNICAL DISCLOSURE BULLETIN, vol. 27, no. 1A, June 1984, page 360, New York, US; R.S. CAPOWSKI: "Dual storage system"
- PATENT ABSTRACTS OF JAPAN, vol. 5, no. 118 (P-073), 30th July 1981; & JP-A-56 058 200 (NEC CORP.) 21-05-1981
- PATENT ABSTRACTS OF JAPAN, vol. 8, no. 89 (P-270), 24th April 1984; & JP-A-59 003 576 (FUJITSU K.K.) 10-01-1984
- IBM TECHNICAL DISCLOSURE BULLETIN, vol. 14, no. 9, February 1972, pages 2811- 2812, New York, US; M.A. AUSLANDER et al.: "Reducing memory contention and increasing reliability in multi-processors with dynamic address translation"
- IBM TECHNICAL DISCLOSURE BULLETIN, vol. 18, no. 1, June 1975, pages 61-62, New York, US; C.E. HOFF et al.: "Selective journaling"

## Description

The present invention relates to a storage control system ensuring the reliability of information stored in a computer system, more particularly, it relates to a storage control system having double memories, a plurality of clusters, and double global storage units to ensure a reliable and high speed processing of information in the computer system.

In a conventional computer system having at least a main storage unit (MSU), a memory control unit (MCU) and processors (CPU's), and storing information from an external stage to the main storage unit, the same information is written to two different areas in the main storage unit, to ensure the reliability of the stored data and to guard against an accidental fault occurrence in the memory (i.e., double-writing). In this case, the information is first stored to one area in the main storage unit, and then the same information is stored to another area in the same main storage unit. Therefore, even if the first stored information is destroyed by an accidental fault, the second stored information is maintained in the other area, and thus the reliability of the information stored in the memory can be ensured.

In the conventional computer system, however, the overall time necessary for storing the information to each of the memory areas in the main storage unit is doubled, and accordingly, this conventional method impedes a high speed processing in the computer system.

A computer system constituted by a plurality of processors (i.e., a multiprocessor system) is known, wherein the plurality of processors is divided into a plurality of groups, each of which is called a "cluster", for a cluster control, and control of an access between processors is performed through each cluster and the global storage unit, for a high-speed processing of the information. Accordingly, the multiprocessor system is constituted by a plurality of clusters and the global storage unit, and each cluster comprises a local storage unit, a memory control unit and, for example, four processors operatively connected to the memory control unit.

In the multiprocessor system, double-writing of the information in the memory must be used to ensure the reliability of the stored information.

Nevertheless, it is impossible to ensure both a high reliability and a high-speed processing of the information in the conventional computer system.

JP-A-56 058 200 by NEC Corp. discloses a storage control system in accordance with the preamble of accompanying claim 1.

JP-A-59 003 576 by the present applicant discloses a multiprocessor system composed of a plurality of multiunit systems, each with individual memories and respective central control units, and a common memory and spare memory both connected in common to all the central control units of the multiunit systems. The spare memory is used to overcome a fault arising in the individual memories of the multiunit systems.

According to the present invention, there is provided a storage control system in a computer system having at least one processor, a main storage unit, and a memory control unit, said storage control system comprising:-
access means, operatively connected to the processor and the main storage unit, for accessing two memory areas provided in said main storage unit, each of said two memory areas being capable of storing identical information; and
double-writing means, provided in said memory control unit and operatively connected to the processor and said access means, and operable to write the identical information to each of said two memory areas using said access means, by determining a state of at least a double-writing bit contained in an address order from the processor, a state of "1" of said D-bit representing a double-writing mode to write the identical information to each of said two memory areas;
characterised in that said D-bit is used for a non-privileged mode, a state of "0" of said D-bit representing a normal writing mode to write information to only one of said two memory areas;
and in that said double-writing means is also operable to determine the state of storage configuration bits stored in the memory control unit, said storage configuration bits being used for a privileged mode and having four possible states in accordance with four permutations of an F-bit and an S-bit for indicating the double-writing mode.

An embodiment of the present invention may provide a storage control system in a computer system enabling high-speed storage of the same write data to each of two areas in a main storage unit, to ensure the reliability of the information.

Thus, the present invention employs both a D-bit and F/S-bits. The D-bit is used for a non-privileged mode and takes two states; a state of "0" representing a normal writing mode for writing the information to one of the two memory areas, and the state of "1" representing a double-writing mode for writing the same information to each of the two memory areas.

The F/S-bits are used for a privileged mode and take four states in accordance with four permutations of the F-bit and the S-bit.

Reference is made, by way of example, to the accompanying drawings, in which:-
Fig. 1 shows a basic structure of a storage control system according to the present invention;
Fig. 2 is a schematic block diagram of a multiprocessor system according to an embodiment of the present invention;
Fig. 3 is a flowchart of a double-writing process according to an embodiment of the present invention; and
Fig. 4 is a schematic block diagram of a memory control unit according to an embodiment of the present invention.

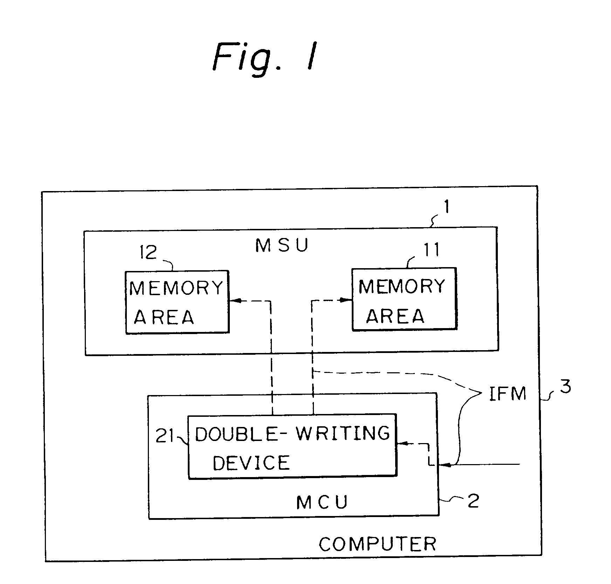

Fig. 1 shows a basic structure of a storage control system according to the present invention.

In Fig. 1, reference number 1 represents a main storage unit (MSU) having two memory areas 11 and 12, 2 a memory control unit (MCU) having a double-writing device 21, and 3 a computer system including these units. The memory control unit 2 controls the reception of information IFM from the external stage to the double-writing device 21. The double-writing device 21 is provided for simultaneously storing the same information IFM to the two different areas 11, 12 in the main storage unit 1.

According to the present invention, since the same information can be written to two different areas in the main storage unit, it is possible to reduce the writing time and ensure the reliability and a high speed processing of the information in the computer system.

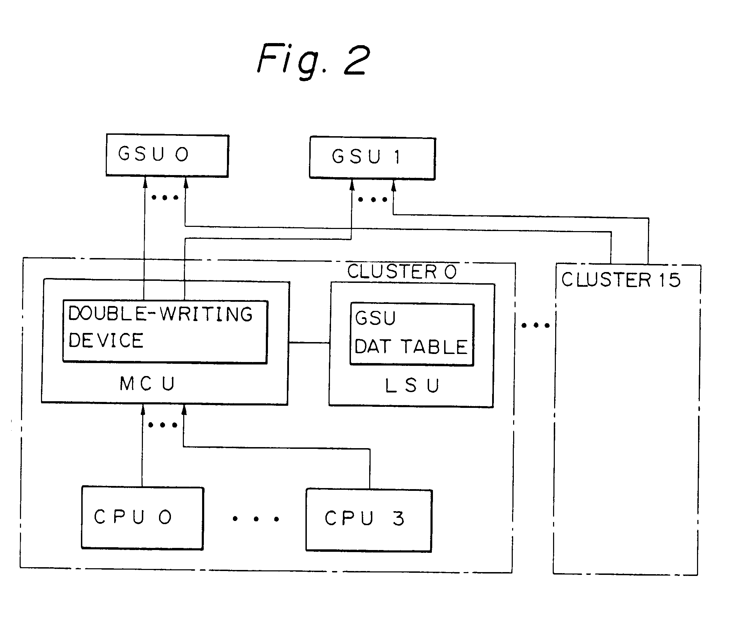

Figure 2 is a schematic block diagram of a multiprocessor system according to an embodiment of the present invention. In Fig. 2, the multiprocessor system is constituted by sixty-four processors, which are divided into sixteen clusters each having four processors CPU0 to CPU3. Each cluster comprises four processors CPU0 to CPU3, a local storage unit LSU, and a memory control unit MCU, and is connected in common to two global storage units GLU0 and GSU1 through bus lines BUS. The global storage unit includes the memory area corresponding to the main storage unit shown in Fig. 1. The local storage unit LSU comprises a DAT (Dynamic Address Translator) table for an address conversion. The DAT-table is used for converting a virtual address to a real address complying with each global storage unit GSU0 to GSU1. Further, the memory control unit MCU comprises a double-writing device DWD for simultaneously storing the same information to each of the global storage units GSU0 and GSU1 in response to an order from the processors CPU0 to CPU3.

The double-writing device DWD does not always store the information to two global storage units GSU0 and GSU1; i.e., in a non-privileged mode and in a cluster executed by using a virtual address, the transfer of information between the global storage unit GSU and the DAT table belonging to that cluster can be controlled in accordance with a state of a D-bit, and accordingly, the D-bit represents a double-writing mode. For example, when the D-bit is "0", one global storage unit (for example, GSU0) is accessed, and when the D-bit is "1", two global storage units GSU0 and GSU1 are accessed simultaneously.

In a privileged mode, an operation is executed by an access order using the real address. In this case the DAT table is not used and the transfer for the writing is controlled in accordance with the state of two kinds of storage configuration bits (F/S-bits; first and second bits) generated from the processor, as shown by a following F/S table.

### F/S table

| F-bit | S-bit | control of writing |
|---|---|---|
| 1 | 1 | write to both GSU0 and GSU1 |
| 1 | 0 | write to only GSU0 |
| 0 | 1 | write to only GSU1 |
| 3 | 0 | exception of address designation |

The term "exception of address designation" means that no area to be accessed can be found.

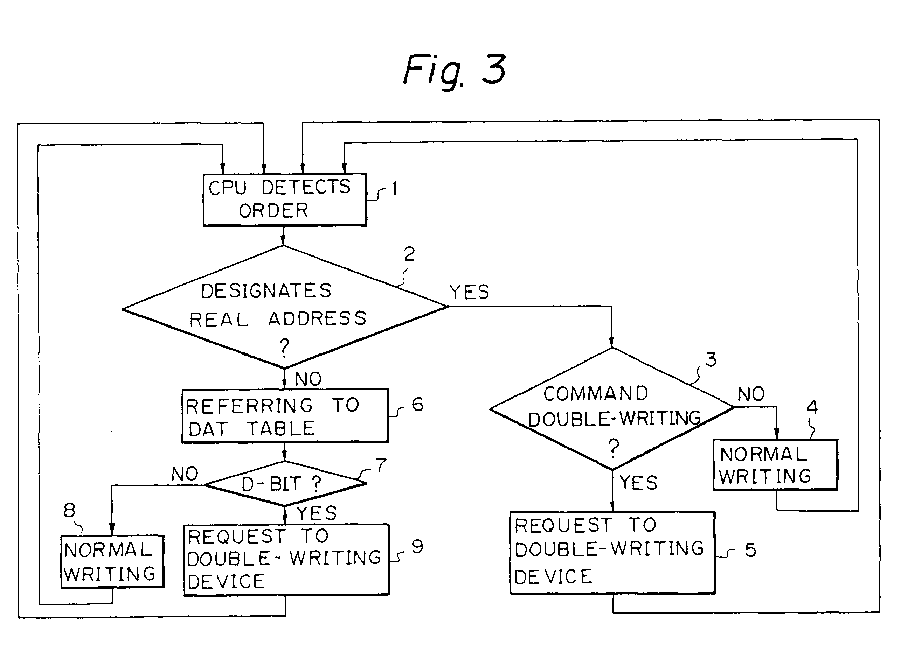

Figure 3 is a flowchart explaining an operation of the storage control system according to an embodiment of the present invention. In Fig. 3, when the processor CPU detects an order (step 1), the processor CPU determines whether or not the order designates the real address of the global storage unit GSU (step 2). When the order designates the real address (YES), the processor CPU sends the order to the memory control unit MCU without referring the DAT table. The memory control unit MCU then determines whether or not the order is a double-writing order by referring to the command of the order (step 3). When the order is not a double-writing order (NO), the memory control unit MCU executes a normal writing (step 4), and when the order is a double-writing order (YES), the memory control unit MCU sends a request for a double-writing to the double-writing device DWD by referring to the F/S table (step 5).

Further, when the order does not designate the real address, as shown by "NO" in step 2, the processor CPU refers to the DAT table and the designation of the address is converted to the real address of the GSU0 (step 6). The memory control unit MCU determines the state of the D-bit designating the double-writing (step 7), and when the D-bit does not rise, the memory control unit MCU executes a normal writing (step 8). When the D-bit rises, the memory control unit sends a request for a double-writing to the double-writing device (step 9).

In this case, when the double-writing device receives the double-writing request from the memory control unit, it automatically generates the double-writing address for one global storage unit corresponding to the writing address for the other global storage unit designated, and simultaneously, transfers the writing request to both global storage units. Therefor, according to the present invention, it is possible to store the information to be written to two global storage units based on a one-time writing operation, and thus it is possible to achieve a high speed processing of the information and to ensure the reliability of the stored information.

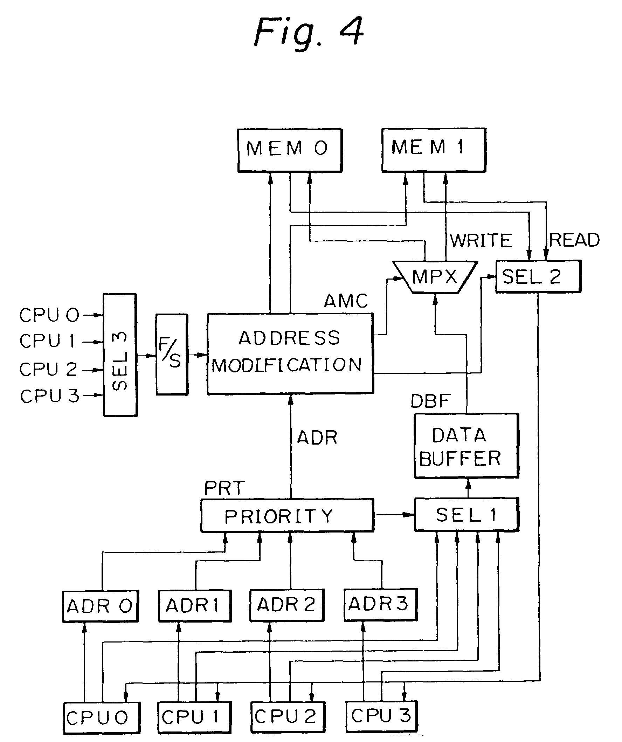

Figure 4 is a schematic block diagram of the memory control unit according to an embodiment of the present invention. In Fig. 4, address translators ADR0 to ADR3 are provided at corresponding processors CPU0 to CPU3, and each of the memories MEM0 and MEM1 is included in corresponding global storage unit GSU0 or GSU1. Namely, for example, the memory MEM0 is included in the global storage unit GSU0 and the memory MEM1 is included in the global storage unit GSU1, respectively. The memory control unit comprises a priority circuit PRT, selectors SEL1 and SEL2, an address modification circuit AMC, a data buffer DBF, a multiplexer MPX, and an F/S-bit table. The double-writing device according to the present invention corresponds to the address modification circuit AMC and the F/S-bit table.

In this structure, for example, the order from the processor CPU1 is input to the address translator ADR1, and when the order designates the real address, it is sent to the priority circuit PRT without a conversion of the address. When the order designates the virtual address, the virtual address is converted to the real address by referring to the DAT table. The priority circuit PRT determines the priority for the orders input from each of address translators ADR0 to ADR3, and the order selected by the priority circuit PRT is sent to the address modification circuit AMC and the first selector SEL1.

The address modification circuit AMC determines whether or not the D-bit is high ("1"), to detect the double-writing mode in the non-privileged mode. When the D-bit is low ("0"), the normal writing mode is executed for the memory through the multiplexer MPX. In this case, the data is transferred from the processor to the memory through the selector SEL1, the data buffer DBF, and the multiplexer MPX. When the D-bit is high, the double-writing is executed to two areas of the memory.

In the privileged mode, the address modification circuit AMC determination is based on the state of the F/S-bit. Namely, as shown by the F/S table, the data is written to the GSU0 and/or GSU1 in accordance with the F/S table, through the multiplexer MPX. The F/S-bit is determined by the processor selected by the priority circuit PRT through the selector SEL3. The selector SEL2 is provided for reading the data from the memory MEM0 or MEM1 to the processor.

## Claims

1. A storage control system in a computer system having at least one processor (CPU; CPU0, CPU1, ...), a main storage unit (MSU), and a memory control unit (MCU), said storage control system comprising:-
access means, operatively connected to the processor and the main storage unit, for accessing two memory areas (GSU0, GSU1; MEM0, MEM1) provided in said main storage unit, each of said two memory areas being capable of storing identical information; and
double-writing means, provided in said memory control unit (MCU) and operatively connected to the processor and said access means, and operable to write the identical information to each of said two memory areas using said access means, by determining a state of at least a double-writing bit (D-bit) contained in an address order from the processor, a state of "1" of said D-bit representing a double-writing mode to write the identical information to each of said two memory areas;
characterised in that said D-bit is used for a non-privileged mode, a state of "0" of said D-bit representing a normal writing mode to write information to only one of said two memory areas (GSU0, GSU1);
and in that said double-writing means is also operable to determine the state of storage configuration bits (F-bit, S-bit) stored in the memory control unit, said storage configuration bits being used for a privileged mode and having four possible states in accordance with four permutations of an F-bit and an S-bit for indicating the double-writing mode.

2. A storage control system according to claim 1, applied to a multiprocessor system having a plurality of processors (CPU0, CPU1, ...) divided into a plurality of clusters (CLUSTER 0, CLUSTER 1, ...) and having two global storage units (GSU0, GSU1) each providing a respective one of said two memory areas; wherein each said cluster is provided with a local storage unit (LSU), a respective said access means and a respective said memory control unit (MCU).

3. A storage control system according to claim 2, further comprising a dynamic address translator in each said local storage unit (LSU) and operatively connected to said double-writing means for converting a virtual address to a real address.

4. A storage control system according to claim 2 or 3, further comprising:-
an F/S-bit table in each said memory control unit (MCU), operatively connected to the processors in the corresponding cluster (e.g. CPU0 to CPU3) and selected by one of the processors; and
an address modification circuit (AMC) in each said memory control unit (MCU), operatively connected to said F/S-bit table and the global storage units (GSUO, GSU1), for determining either the normal writing mode or the double-writing mode based on the state of the D-bit in the non-privileged mode and based on the storage configuration bits in the privileged mode.

5. A storage control system according to claim 1 or 2, wherein address means (e.g. ADR0 to ADR3) are operatively connected to the or each processor (e.g. CPU0 to CPU3), for receiving a first write address for data received from the processor; and wherein the or each processor is operable to provide control data including an indication of whether the non-privileged access mode is used and a storage configuration signal indicating areas of the main storage to be written to in the privileged mode, said double-write means including an address modification circuit (AMC) for generating a second write address in the main storage unit in dependence upon the first write address received by said address means, when the double-write signal indicates that the identical data is to be written to the more than one area in the main storage unit (MSU).

6. A storage control system according to claim 5:-
wherein the or each said memory control unit (MCU) further comprises a storage configuration table, operatively connected to the or each processor for determining the areas of the main storage unit (MSU) indicated by the storage configuration signal; and
wherein said address modification circuit (AMC) generates the second write address in the privileged mode in dependence upon the areas of the main storage unit determined by said storage configuration table.

7. A storage control system according to claim 6, further comprising:-
a data buffer (DBF) for receiving the data from the or each processor (e.g. CPU0 to CPU3); and
means (MPX) for supplying the data from said data buffer to the areas of the main storage unit (MSU) under control of said address modification circuit (AMC).

## Patentansprüche

1. Ein Speichersteuersystem in einem Computersystem, das wenigstens einen Prozessor (CPU; CPU0, CPU1, ...), eine Hauptspeichereinheit (MSU) und eine Speichersteuereinheit (MCU) hat, welches Speichersteuersystem umfaßt:-
ein Zugriffsmittel, das mit dem Prozessor und der Hauptspeichereinheit operativ verbunden ist, zum Zugreifen auf zwei Speicherbereiche (GSU0, GSU1; MEM0, MEM1), die in der genannten Hauptspeichereinheit vorgesehen sind, von welchen zwei Speicherbereichen jeder identische Informationen speichern kann; und
ein Doppelschreibmittel, das in der genannten Speichersteuereinheit (MCU) vorgesehen ist und mit dem Prozessor und dem genannten Zugriffsmittel operativ verbunden ist, und das betriebsfähig ist, um die identischen Informationen unter Verwendung des genannten Zugriffsmittels in jeden der genannten zwei Speicherbereiche zu schreiben, indem ein Zustand von wenigstens einem Doppelschreibbit (D-Bit), das in einer Adressenanweisung von dem Prozessor enthalten ist, bestimmt wird, wobei ein Zustand von "1" des genannten D-Bits einen Doppelschreibmodus darstellt, um die identischen Informationen in jeden der genannten zwei Speicherbereiche zu schreiben;
dadurch gekennzeichnet, daß das genannte D-Bit für einen nichtprivilegierten Modus verwendet wird, wobei ein Zustand von "0" des genannten D-Bits einen normalen Schreibmodus darstellt, um Informationen in nur einen der genannten zwei Speicherbereiche (GSU0, GSU1) zu schreiben;
und daß das genannte Doppelschreibmittel auch betriebsfähig ist, um den Zustand von Speicherkonfigurationsbits (F-Bit, S-Bit) zu bestimmen, die in der Speichersteuereinheit gespeichert sind, welche Speicherkonfigurationsbits für einen privilegierten Modus verwendet werden und gemäß vier Permutationen eines F-Bits und eines S-Bits zum Angeben des Doppelschreibmodus vier mögliche Zustände haben.

2. Ein Speichersteuersystem nach Anspruch 1, das auf ein Mehrprozessorsystem angewendet ist, das eine Vielzahl von Prozessoren (CPU0, CPU1, ...) hat, die in eine Vielzahl von Clusters (CLUSTER 0, CLUSTER 1, ...) unterteilt sind, und zwei globale Speichereinheiten (GSU0, GSU1) hat, die jeweils einen entsprechenden der genannten zwei Speicherbereiche vorsehen; bei dem jeder genannte Cluster mit einer lokalen Speichereinheit (LSU), einem entsprechenden genannten Zugriffsmittel und einer entsprechenden genannten Speichersteuereinheit (MCU) versehen ist.

3. Ein Speichersteuersystem nach Anspruch 2, das ferner einen dynamischen Adressenumsetzer in jeder genannten lokalen Speichereinheit (LSU) umfaßt, der mit dem genannten Doppelschreibmittel operativ verbunden ist, zum Konvertieren einer virtuellen Adresse in eine reale Adresse.

4. Ein Speichersteuersystem nach Anspruch 2 oder 3, ferner mit:-
einer F/S-Bit-Tabelle in jeder genannten Speichersteuereinheit (MCU), die mit den Prozessoren in dem entsprechenden Cluster (z. B. CPU0 bis CPU3) operativ verbunden ist und durch einen der Prozessoren selektiert wird; und
einer Adressenmodifikationsschaltung (AMC) in jeder genannten Speichersteuereinheit (MCU), die mit der genannten F/S-Bit-Tabelle und den globalen Speichereinheiten (GSU0, GSU1) operativ verbunden ist, zum Bestimmen entweder des normalen Schreibmodus oder des Doppelschreibmodus auf der Basis des Zustandes des D-Bits in dem nichtprivilegierten Modus und auf der Basis der Speicherkonfigurationsbits in dem privilegierten Modus.

5. Ein Speichersteuersystem nach Anspruch 1 oder 2, bei dem ein Adressenmittel (z. B. ADR0 bis ADR3) mit dem oder jedem Prozessor (z. B. CPU0 bis CPU3) operativ verbunden ist, zum Empfangen einer ersten Schreibadresse für Daten, die von dem Prozessor empfangen werden; und bei dem der oder jeder Prozessor betriebsfähig ist, um Steuerdaten vorzusehen, die eine Angabe bezüglich dessen enthalten, ob der nichtprivilegierte Zugriffsmodus verwendet wird, und ein Speicherkonfigurationssignal, das im privilegierten Modus Bereiche des Hauptspeichers angibt, die zu beschreiben sind, welches Doppelschreibmittel eine Adressenmodifikationsschaltung (AMC) enthält, zum Erzeugen einer zweiten Schreibadresse in der Hauptspeichereinheit in Abhängigkeit von der ersten Schreibadresse, die durch das genannte Adressenmittel empfangen wurde, wenn das Doppelschreibsignal angibt, daß die identischen Daten in die mehreren Bereiche als in einen Bereich in der Hauptspeichereinheit (MSU) zu schreiben sind.

6. Ein Speichersteuersystem nach Anspruch 5:-
bei dem die oder jede genannte Speichersteuereinheit (MCU) ferner eine Speicherkonfigurationstabelle umfaßt, die mit dem oder jedem Prozessor operativ verbunden ist, zum Bestimmen der Bereiche der Hauptspeichereinheit (MSU), die durch das Speicherkonfigurationssignal bezeichnet sind; und
bei dem die genannte Adressenmodifikationsschaltung (AMC) die zweite Schreibadresse in dem privilegierten Modus in Abhängigkeit von den Bereichen der Hauptspeichereinheit erzeugt, die durch die genannte Speicherkonfigurationstabelle bestimmt sind.

7. Ein Speichersteuersystem nach Anspruch 6, ferner mit:-
einem Datenpuffer (DBF) zum Empfangen der Daten von dem oder jedem Prozessor (z. B. CPU0 bis CPU3); und
einem Mittel (MPX) zum Zuführen der Daten von dem genannten Datenpuffer zu den Bereichen der Hauptspeichereinheit (MSU) unter Steuerung der genannten Adressenmodifikationsschaltung (AMC).

## Revendications

1. Système de commande de mémorisation d'un système informatique possédant au moins un processeur (CPU ; CPU0, CPU1, ...), une unité principale de mémorisation (MSU), et une unité de commande de mémoire (MCU), ledit système de commande de mémorisation comprenant :
un moyen d'accès, fonctionnellement connecté au processeur et à l'unité principale de mémorisation, permettant de faire accès à deux zones de mémoire (GSU0, GSU1 ; MEM0, MEM1) prévues dans ladite unité principale de mémorisation, chacune desdites deux zones de mémoire étant en mesure de mémoriser une information identique ; et
un moyen de double écriture, prévu dans ladite unité de commande de mémoire (MCU) et fonctionnellement connecté au processeur et audit moyen d'accès, ayant pour fonction d'écrire l'information identique dans chacune desdites deux zones de mémoire à l'aide dudit moyen d'accès, par détermination de l'état d'au moins un bit de double écriture (bit D) contenu dans un ordre d'adresse venant du processeur, l'état "1" dudit bit D représentant un mode de double écriture qui vise à faire écrire l'information identique dans chacune desdites deux zones de mémoire ;
caractérisé en ce que ledit bit D est utilisé pour un mode non privilégié, l'état "0" dudit bit D représentant un mode d'écriture normale qui vise à faire écrire l'information dans une seule desdites deux zones de mémoire (GSU0, GSU1);
et en ce que ledit moyen de double écriture a également pour fonction de déterminer l'état de bits de configuration de mémorisation (bit F, bit S) mémorisés dans l'unité de commande de mémoire, lesdits bits de configuration de mémorisation étant utilisés pour un mode privilégié et ayant quatre états possibles selon les quatre permutations du bit F et du bit S, afin d'indiquer le mode de double écriture.

2. Système de commande de mémorisation selon la revendication 1, appliqué à un système multiprocesseur possédant une pluralité de processeurs (CPU0, CPU1,...) divisés en une pluralité de grappes (CLUSTER 0, CLUSTER 1,....) et ayant deux unités globales de mémorisation (GSU0, GSU1) fournissant chacune l'une respective desdites deux zones de mémoire ; où chaque dite grappe est dotée d'une unité locale de mémorisation (LSU), d'un dit moyen d'accès respectif et d'une dite unité de commande de mémoire (MCU) respective.

3. Système de commande de mémorisation selon la revendication 2, comprenant en outre une unité de translation d'adresse dynamique disposée dans chaque dite unité locale de mémorisation (LSU) et fonctionnellement connectée audit moyen de double écriture afin de convertir une adresse virtuelle en une adresse réelle.

4. Système de commande de mémorisation selon la revendication 2 ou 3, comprenant en outre :
une table de bits F/S prévue dans chaque dite unité de commande de mémoire (MCU), fonctionnellement connectée aux processeurs de la grappe correspondante (par exemple CPU0 à CPU3) et sélectionnée par l'un des processeurs ; et
un circuit de modification d'adresse (AMC) prévu dans chaque dite unité de commande de mémoire (MCU), fonctionnellement connecté à ladite table de bits (F/S) et aux unités globales de mémorisation (GSU0, GSU1) afin de déterminer s'il s'agit du mode d'écriture normale ou du mode de double écriture à partir de l'état du bit D dans le mode non privilégié et à partir des bits de configuration de mémorisation dans le mode privilégié.

5. Système de commande de mémorisation selon la revendication 1 ou 2, où des moyens d'adressage (par exemple ADR0 à ADR3) sont fonctionnellement connectés au processeur ou à chaque processeur (par exemple CPU0 à CPU3), afin de recevoir une première adresse d'écriture se rapportant à une donnée reçue de la part du processeur ; et où le processeur ou chaque processeur a pour fonction de fournir une donnée de commande incluant une indication du fait que le mode d'accès non privilégié est ou non utilisé et un signal de configuration de mémorisation indiquant des zones de l'unité principale de mémorisation où il faut écrire dans le mode privilégié, ledit moyen de double écriture comportant un circuit de modification d'adresse (AMC) servant à produire un deuxième signal d'écriture dans l'unité principale de mémorisation en fonction de la première adresse d'écriture reçue par lesdits moyens d'adressage, lorsque le signal de double écriture indique que la donnée identique doit être écrite dans plus d'une zone de l'unité principale de mémorisation (MSU).

6. Système de commande de mémorisation selon la revendication 5, où:
ladite unité de commande de mémoire ou chaque dite unité de commande de mémoire (MCU) comprend en outre une table de configuration de mémorisation, fonctionnellement connectée au processeur ou à chaque processeur afin de déterminer les zones de l'unité principale de mémorisation (MSU) indiquées par le signal de configuration de mémorisation ; et
ledit circuit de modification d'adresse (AMC) produit la deuxième adresse d'écriture dans le mode privilégié en fonction des zones de l'unité principale de mémorisation déterminées par ladite table de configuration de mémorisation.

7. Système de commande de mémorisation selon la revendication 6, comprenant en outre :
un tampon de donnée (DBF) destiné à recevoir la donnée de la part du processeur ou de chaque processeur (par exemple CPU0 à CPU3) ; et
un moyen (MPX) servant à fournir la donnée, provenant dudit tampon de donnée, aux zones de l'unité principale de mémorisation (MSU) sous commande dudit circuit de modification d'adresse (AMC).
